# EUROPEAN PATENT SPECIFICATION

(11) **EP 3 395 783 B1**
(45) Date of publication and mention of the grant of the patent: **25.09.2019**
(21) Application number: 17168793.2
(22) Date of filing: 28.04.2017
(51) Int. Cl.: C04B 35/626, C04B 37/02, H01L 23/00

(54) **METHOD FOR PRODUCING A SINTERED JOINT BETWEEN A CERAMIC SUBSTRATE AND A CARRIER**
VERFAHREN ZUR HERSTELLUNG EINER GESINTERTEN VERBINDUNG ZWISCHEN EINEM KERAMIKSUBSTRAT UND EINEM TRÄGER
PROCÉDÉ DE PRODUCTION D'UN JOINT FRITTÉ ENTRE UN SUBSTRAT CÉRAMIQUE ET UN SUPPORT

(43) Date of publication of application: 31.10.2018
(73) Proprietor: Infineon Technologies AG, 85579 Neubiberg (DE)
(72) Inventor: Boenig, Guido, 59581 Warstein (DE); Trichy Rengarajan, Gopalakrishnan, 59557 Lippstadt (DE)
(74) Representative: Westphal, Mussgnug & Partner Patentanwälte mbB

(56) References cited:
- US-A- 5 486 976
- US-A1- 2015 028 725
- US-A1- 2016 148 819

## Description

### TECHNICAL FIELD

The instant disclosure relates to a method for producing a sintered joint between a ceramic substrate and a carrier.

### BACKGROUND

Ceramic substrates are widely used as circuit boards in power electronic modules or other electronic assemblies. Compared with conventional non-ceramic printed circuit boards, ceramic substrates can withstand high temperatures, exhibit high thermal conductivities and have high insulation strengths. In order to mechanically stabilize the ceramic substrate and/or to improve the dissipation of heat generated by an electronic component mounted on the ceramic substrate, the ceramic substrates are frequently joined with a carrier using a substance bond, e.g. by soldering. However, it has been shown that cracks in the ceramic layer of a ceramic substrate joined with a carrier can occur during the production of a composite that includes a ceramic substrate joined with a carrier.

US 2016/148819 A1 discloses a method for producing a material-bonding connection between a semiconductor chip and a metal layer. For this purpose, a semiconductor chip, a metal layer, which has a chip mounting portion, and a bonding medium formed as a paste and containing a metal powder are provided. The paste can is applied to a chip mounting portion of the metal layer and/or to the semiconductor chip and subsequently dried. Then, the semiconductor chip is placed onto the dried paste on the chip mounting portion using a placing tool. The placing tool may be heated, so that the semiconductor chip picked up by it is preheated before it is placed onto the dried paste. Optionally, the metal layer may be heated, so that the paste applied to the chip mounting portion is preheated by way of the metal layer. The subsequent sintering of the metal powder contained in the paste takes place in a sintering process in which, throughout a prescribed sintering time, the prescribed requirements are met, that the paste is arranged between the semiconductor chip and the metal layer and extends right through from the semiconductor chip to the metal layer, that the semiconductor chip and the metal layer are pressed against one another in a pressing-pressure range that lies above a minimum pressing pressure, that the paste is kept in a temperature range that lies above a minimum temperature and that a sound signal SUS is introduced into the paste.

US 2015/028725 A1 discloses a method of manufacturing an ultrasonic transducer. The method includes: alternatively stacking a ceramic wafer and an electrode wafer, placing between each ceramic wafer and its two neighbouring electrodes a composition that includes silver nanoparticles; and compressing the stack and heating it to a temperature of less than or equal to 280° C. The pressure for compressing the stack can be applied by pre-heatable plates of a press.

US 5 486 976 A relates to a monolithic capacitive differential pressure transducer that is composed of ceramic material and includes a motion transfer pin and opposing capacitor plates. Component parts are first pressed from ceramic powder and assembled into a unit using. The unit is sintered under raised temperatures and pressure in order to form a monolithic body.

A need has been identified for a method for forming a substance-bond between a ceramic substrate and a carrier that prevents or at least reduces the risk of cracks in the ceramic layer of the ceramic substrate.

### SUMMARY

A method for producing a sintered joint between a ceramic substrate and a carrier is disclosed. The ceramic substrate includes a ceramic layer, a first substrate metallization layer attached to the ceramic layer and a second substrate metallization layer attached to the ceramic layer. The ceramic layer is disposed between the first substrate metallization layer and the second substrate metallization layer. The second substrate metallization layer is patterned to include at least two conductor tracks disposed distant from one another. The method includes pre-heating the carrier by increasing a temperature of the carrier from an initial temperature to at least a first threshold temperature. A pressure, with which the pre-heated carrier, the ceramic substrate and a
powder-including layer disposed between the pre-heated carrier and the ceramic substrate and adjoining both the carrier and the first substrate metallization layer are pressed against one another, is increased from an initial pressure of less than or equal to an initial pressure threshold to at least a first pressure threshold, and the powder-including layer is sintered by simultaneously keeping the pressure for at least a minimum sintering time at at least the first pressure threshold and the temperature of the carrier at at least the first temperature threshold so that the powder-including layer is converted into a joining layer joining the carrier and the ceramic substrate. Thereby, the first temperature threshold is a temperature which allows for sintering the powder-including layer when it is heated to that temperature.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional side view of an electronic assembly that includes a composite with a ceramic substrate bonded to a carrier.
Figure 2 is a cross-sectional side view of the ceramic substrate, the carrier and a powder-including layer disposed in-between.
Figure 3 is a cross-sectional side view of the ceramic substrate, the powder-including layer and the carrier stacked one upon the other and inserted in a pressing tool.
Figure 4 is a top view of the arrangement of Figure 3.
Figure 5 is a cross-sectional side view of the arrangement of Figure 3 during sintering of the powder-including layer.
Figure 6 shows timing diagrams of the temperature and pressure employed in the sintering process.
Figure 7 is a cross-sectional side view of an arrangement that differs from the arrangement of Figure 5 in that the carrier 1 has cooling fins.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. As well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element".

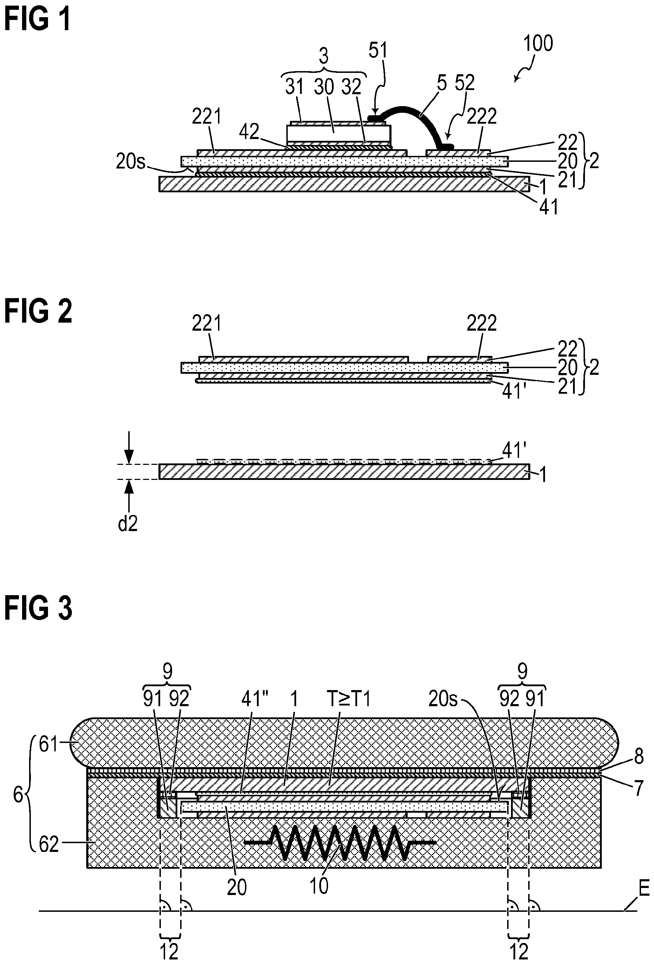

Referring to Figure 1, an exemplary electronic assembly 100 includes a composite with a carrier 1, a ceramic substrate 2, and a first joining layer 41 joining the carrier 1 and the ceramic substrate 2. The ceramic substrate 2 includes a dielectric ceramic layer 20, a first substrate metallization layer 21 and a second substrate metallization layer 22. The first substrate metallization layer 21 and the second substrate metallization layer 22 are attached to opposite surfaces of the ceramic layer 20. As illustrated, the second substrate metallization layer 22 is patterned to include at least two conductor tracks 221, 222 disposed distant from one another.

The dielectric ceramic layer 20 may be made of any dielectric ceramic material, e.g. alumina (Al₂O₃), aluminum nitride (AlN) or silicon nitride (Si₃N₄), so that it can provide for an electrical insulation between the first substrate metallization layer 21 and the second substrate metallization layer 22, or at least for an electrical insulation between a conductor track formed in the first substrate metallization layer 21 and a further conductor track formed in the second substrate metallization layer 22. If it is desired that the ceramic layer 20 electrically insulates the first substrate metallization layer 21 from the second substrate metallization layer 22, it may be free of electrically conductive vias. Alternatively, however, the ceramic layer 20 of a ceramic substrate 2 may include one or more electrically conductive vias electrically connecting the first substrate metallization layer 21 and the second substrate metallization layer 22.

The first substrate metallization layer 21 and the second substrate metallization layer 22 may include any metal, e.g. copper or aluminum, or metal alloy and be attached to opposite surfaces of the ceramic layer 20 using any joining technique, e.g. brazing, direct copper bonding (DCB) or direct aluminum bonding (DAB). Optionally, at its side facing away from the ceramic layer 20, the first substrate metallization layer 21 may include a thin coating, for example in order to improve the sinterability. Irrespective of whether the first substrate metallization layer includes a coating or not, the second substrate metallization layer 22 may, at its side facing away from the ceramic layer 20, include a thin coating, for example in order to improve the solderability or the sinterability, or to protect the second substrate metallization layer 22 against oxidation. A suitable coating for improving the solderability is, e.g., a layer consisting of or including Ni, and a suitable coating for improving the sinterability is, e.g., a layer consisting of or including a noble metal, e.g., Ag or Au or Pd.

The carrier 1 serves to mechanically stabilize the ceramic substrate 2. In order to provide for a proper stabilization, the carrier 1 may have, without being restricted to, a thickness d2 of at least 2 mm. The carrier 1 may consist of or include metal. For instance, the substrate 1 may include at least 95 weight% copper or at least 95 weight% aluminum, or it may consist of or include a metal-matrix-composite (MMC) material like aluminum silicon carbide or any other MMC-material.

The first joining layer 41 adjoins both the carrier 1 and the ceramic substrate 2 and causes a substance-to-substance bond between the carrier 1 and the ceramic substrate 2. As will be explained in more detail below, the first joining layer 41 is formed by sintering a powder during a sintering process which includes a pressing and temperature process.

Disposed on that side of the second substrate metallization layer 22 facing away from the ceramic layer 20 is an electronic component 3, e.g. a power semiconductor chip. An example of an electronic component 3 formed as a power semiconductor chip is illustrated in Figure 1. The power semiconductor chip includes a semiconductor body 30, a first chip metallization layer 31 and a second chip metallization layer 32. A second joining layer 42 creating a substance-to-substance bond between the ceramic substrate 2 and the electronic component 3 adjoins both the ceramic substrate 2 (e.g. that surface of the second metallization layer 22 facing away from the ceramic layer 20) and the electronic component 3 (here: that surface of the second chip metallization layer 32 facing away from the semiconductor body 30). The second joining layer 42 may be a solder layer, a layer including a sintered metal powder, or a layer of an electrically conductive or electrically insulating adhesive.

Using the ceramic substrate 2 as a circuit board forms basis the realization of any desired electronic circuit. That is, an arbitrary number of electronic components may be disposed on the ceramic substrate 2 and electrically interconnected using any type of interconnects 5, e.g. bonding wires (as shown), metal sheets (not shown), etc. In the example illustrated in Figure 1, a bonding wire 5 is, at a first bonding location 51, wire bonded to the first chip metallization layer 31, and, at a second bonding location 52, to the second substrate metallization layer 22. According to the illustrated example, the semiconductor chip 3 may be mounted on a first conductor track 221 formed in the second substrate metallization layer 22 (so that the second joining layer 42 adjoins the first conductor track 221 and joins the semiconductor chip 3 to the ceramic substrate 2 at the first conductor track 221). The first bonding location 51 may be a location at the first chip metallization layer 31, and the second bonding location 52 may be a location at a second conductor track 222 formed in the second substrate metallization layer 22.

Figure 2 illustrates the carrier 1 and the ceramic substrate 2 prior to being joined. In order to join the carrier 1 and the ceramic substrate 2, a powder-including layer 41' may be applied to that surface of the first substrate metallization layer 21 facing away from the ceramic layer 20, and/or a powder-including layer 41' may be applied to the carrier 1. The powder included in the powder-including layer(s) 41' may be a metal powder, e.g. a silver powder. The powder-including layer(s) 41' may be applied to the first substrate metallization layer 21 or the carrier 1, respectively, in the form of a paste including the metal powder and a solvent. After applying the powder-including layer(s) 41', it may be dried by evaporating most of the solvent so that metal powder remains on the first substrate metallization layer 21 or the carrier 1. If there is only one powder-including layer(s) 41', the paste may be applied to either the first substrate metallization layer 21 or the carrier 1 and be subsequently dried. Then, the dried layer 41' may be disposed between the carrier 1 and the substrate metallization layer 21 so that that the dried layer 41' forms a powder-including layer 41" (Figure 3) that adjoins both the carrier 1 and the substrate metallization layer 21.

If there are two powder-including layers 41', the paste may be applied to both the first substrate metallization layer 21 or the carrier 1 and be subsequently dried so that one dried powder-including layer 41' adheres to the carrier 1 and a further dried powder-including layer 41' adheres to the first substrate metallization layer 21. Subsequently, the dried powder-including layers 41' may be disposed between the carrier 1 and the substrate metallization layer 21 so that that they unify to a powder-including layer 41" (Figure 3) that adjoins both the carrier 1 and the substrate metallization layer 21.

Subsequently, the metal powder included in the powder-including layer 41" will be sintered during a sintering process so as to form from it the first joining layer 41 described above with reference to Figure 1. As illustrated in Figure 3, sintering takes place using a pressing tool 6. The pressing tool 6 includes a first pressing tool element 61 and a second pressing tool element 62. The stack including the carrier 1, the ceramic substrate 2 and the powder-including layer 41" disposed in-between is placed between the first pressing tool element 61 and the second pressing tool element 62, and, subsequently, the carrier 1 and the ceramic substrate 2 with the powder-including layer 41" disposed in-between are pressed against one another by pressing the first pressure piece 61 and the second pressure piece 62 towards one another..

Optionally, a foil layer which includes at least one foil 7, 8 may be disposed between the first pressing tool element 61 on the one hand and the stack with the carrier 1, the ceramic substrate 2 and the powder-including layer 41" disposed in-between on the other. According to one option, the foil layer may include a non-stick foil 8, e.g. made of polytetrafluoroethylene, which makes sure that the first pressing tool element 61 can, after the pressing process, be removed from the second pressing tool element 62, from the composite including the carrier 1, the ceramic substrate 2 and the first joining layer 41 disposed in-between, and, if present, from one or more further foils (here: a metal foil 7) of the foil layer disposed between the non-stick foil 8 and the mentioned composite. A suitable thickness of the non-stick 8 may be, without being restricted to, 100 µm.

According to another option, the foil layer may include a metal foil 7 (e.g. made of hardened steel) that is disposed between the first pressing tool element 61 on the one hand and the stack with the carrier 1, the ceramic substrate 2 and the powder-including layer 41" disposed in-between on the other. The metal foil 7 serves to protect in particular the substrate from being damaged during the pressing process, e.g. when the first pressing tool element 61 is a flexible pressure pillow that allows for applying an approximately hydrostatic (i.e. evenly distributed) pressure to one side of the mentioned stack. Depending on the dimensions of the pressing tool 6, the flexibility of the first pressing tool element 61 formed as a pressure pillow, and the orientation of the stack inserted in the pressing tool 6, a first pressing tool element 61 formed as a pressure pillow might partly be pressed into a gap between the second pressing tool element 62 and the mentioned stack and cause a crack of the substrate 2, in particular of the ceramic layer 20. If the gap between the second pressing tool element 62 and the mentioned stack is not too wide, the metal foil 7 can prevent the first pressing tool element 61 formed as a flexible pressure pillow from being pressed into the gap. A suitable thickness of the metal foil 7 is, without being restricted to, 100 µm.

The second tool element 62 is made of a hard material. For instance, the second tool element 62 may have, without being restricted to, a rockwell hardness of at least 29. A suitable material having a rockwell hardness of at least 29 is, for instance, AMPCO® 21 (an alloy including at least 80,0 weight% Cu; 13.1 weight% Al; 4.4 weight% Fe; 2.0 weight% Mn; other: less than or equal to 0.5 weight%).

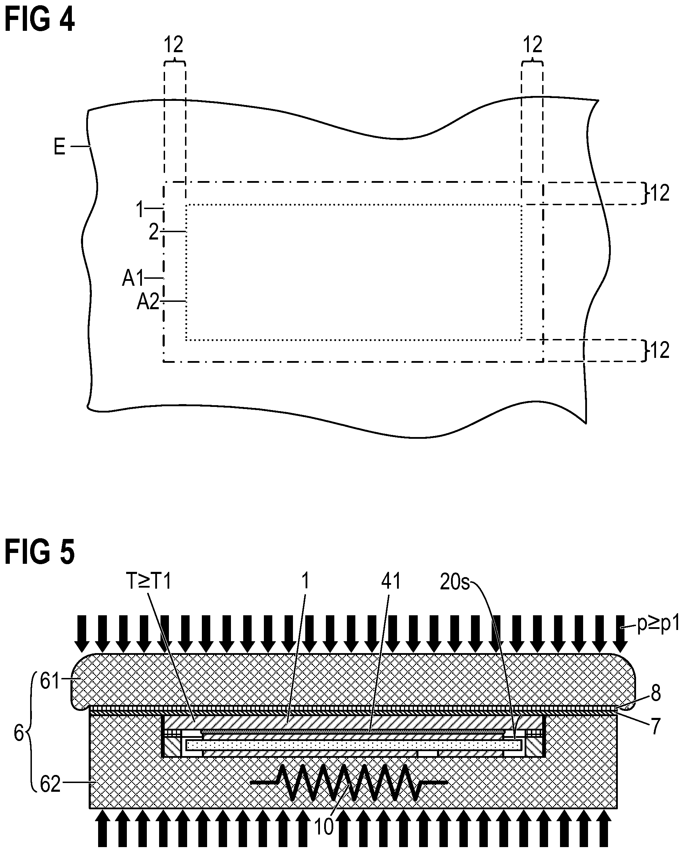

An alternative or additional means for preventing the formation of a crack of the substrate 2 during the pressing process is the use of a carrier 1 that laterally extends at least as far as or even beyond the substrate 2 so that it "shields" the substrate 2 from damaging impacts caused by a first pressing tool element 61 formed as a flexible pressure pillow. In this regard, "laterally" designates a direction parallel to a surface of the ceramic layer 20 facing toward the carrier 1. In order to produce that shielding effect, the carrier 1 is disposed between the substrate 2 and the first pressing tool element 1. In Figure 3, reference numeral '12' designates the lateral overhang the carrier 1 has relative to the ceramic substrate 2. The lateral overhang 12 may be determined from an orthogonal projection of the carrier 1 and the substrate 2 of the mentioned stack onto a projection plane E. A top view of the projection plane E of Figure 3 is illustrated in Figure 4. In Figure 4, the outline of the projection of the carrier 1 into the projection plane E has is indicated by a dot and dash line, and the outline the projection of the substrate 2 into the projection plane E has is indicated by a dotted line. The projection plane E may run parallel to a surface or surface section 20s of the ceramic layer 20 facing toward the carrier 1. If the substrate 2 has a substantially flat shape, the orientation of the projection plane E is substantially parallel to the substrate 2. The direction of the projection runs perpendicular to the projection plane E. As can be seen from Figure 4, a lateral overhang 12 can be achieved when the carrier 1 has a (maximum) footprint area A1 greater than a (maximum) footprint area A2 of the ceramic substrate 2.

According to another option, the lateral overhang 12 in the projection plane E may everywhere be greater than zero so that the outline of the projection of the substrate 2 into the projection plane E is fully inside but distant from the outline of the projection of the carrier 1 into the projection plane E (that is, the lateral overhang 12 is a closed ring that everywhere has a width greater than zero).

At locations where the carrier 1 has a lateral overhang 12 greater than zero, a spacer 9 may, adjacent to the substrate 2, be disposed between the second pressing tool element 62 and the carrier 1 (in the region of the lateral overhang 12) in order to support the carrier 1 when the latter is pressed by the first pressing tool element 61 towards the second pressing tool element 62. The spacer 9 can prevent the carrier 1 from being bent by the first pressing tool element 61. During the pressing process, the powder-including layer 41" is compressed and its thickness is reduced. Therefore, the height of such a spacer 9 (if used) may be adjusted to the sum of the thickness of the substrate 2 and the desired thickness of the completed first joining layer 41 to be produced by the sintering process. The spacer 9 includes at least one distance piece 91 and, optionally, at least one adjustment piece 92 stacked on the distance piece 91 so that the total height of the spacer 9 is equal to the sum of the thickness of the substrate 2 and the desired thickness of the first joining layer 41 to be produced. For instance, the distance piece 91, and, as far as provided, each adjustment piece 92 may be a ring surrounding the substrate 2.

In order to form the first joining layer 41 (Figure 1) from the powder-including layer 41" (Figure 3), the powder included in the powder-including layer 41" is sintered during a sintering process in which the powder-including layer 41" is compressed and heated to temperatures significantly higher than room temperature. Heating the powder-including layer 41" to high temperatures also causes the carrier 1 and the substrate 2 to heat up and, as a consequence, to expand depending on their respective coefficient of thermal expansion. The coefficient of thermal expansion (CTE) of the substrate 2 is significantly determined by the coefficient of thermal expansion of the ceramic layer 20 and the coefficient(s) of thermal expansion of the first and second substrate metallization layers 21, 22. If the CTE of the carrier 1 exceeds the CTE of the substrate 2, heating the carrier 1, the ceramic substrate 2 and the powder-including layer 41" disposed in-between in a state in which the carrier 1, the ceramic substrate 2 and the powder-including layer 41" are pressed against one another at a high pressure, to high temperatures will cause a tensile load on the substrate 2 and, thus, on the ceramic layer 20. Because the strength of ceramics against tensile loads is poor, there is a significant risk of a crack occurring in the ceramic layer 20 during the sintering process.

In order to prevent such cracks, the carrier 1 is pre-heated, and a high pressure with which the carrier 1, the ceramic substrate 2 and the powder-including layer 41" disposed in-between are pressed against one another in order to sinter the powder-including layer 41", is applied when the carrier 1 has already reached the pre-heated state. Applying the high pressure may substantially be caused by pressing the pre-heated carrier 1 and the ceramic substrate 2 with the powder-including layer 41" disposed in-between against one another by pressing the first pressure piece 61 and the second pressure piece 62 towards one another.

By sintering the powder-including layer 41", the powder-including layer 41" is converted into the first joining layer 41 (Figure 1) and causes a firm substance-to-substance bond between the carrier 1 and the ceramic substrate 2. Because the CTE of the carrier 1 exceeds the CTE of the substrate 2, subsequently cooling down the achieved assembly which includes the carrier 1, the ceramic substrate 2 and the first joining layer 41 joining the carrier 1 and the ceramic substrate 2 to, e.g., room temperature (20°C), a compressive load on the substrate 2 and, thus, on the ceramic layer 20 is caused. Because the compressive strength of ceramics is significantly higher than its tensile strength, the pre-heating helps prevent the formation of cracks in the ceramic layer 20.

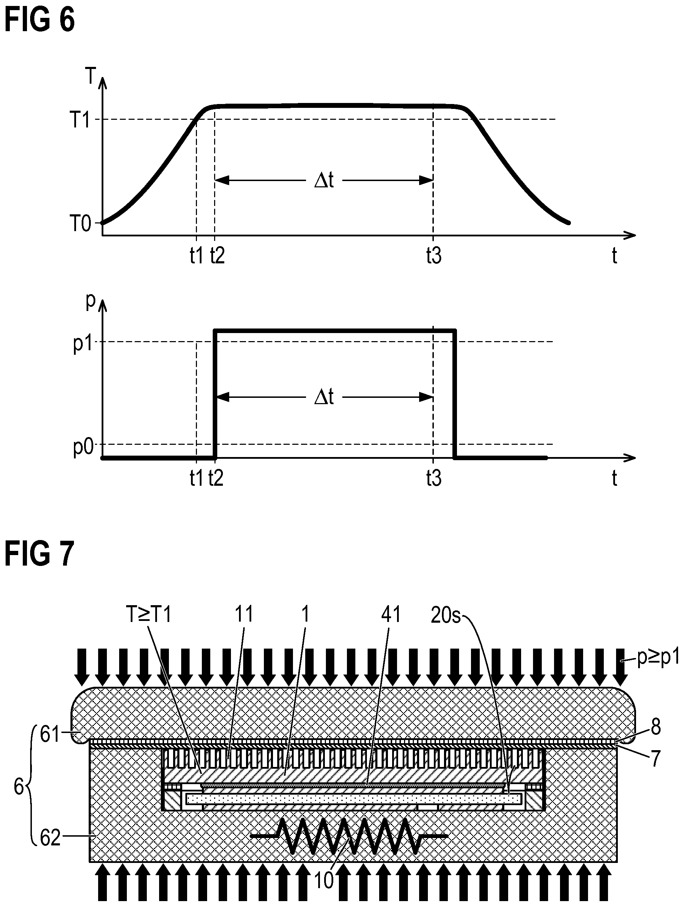

Referring to the Figure 6, the steps of pre-heating and sintering outlined above will be described in more detail below. Thereby, "T" designates a temperature of the carrier 1, and "p" designates a pressure (if any) with which the carrier 1, the ceramic substrate 2 and the powder-including layer 41" disposed in-between are pressed against one another. The upper diagram illustrates the temperature T depending on the time t, and the upper diagram illustrates the temperature T depending on the time t, and the upper diagram illustrates the pressure depending on the time t. The time scales of both diagrams are identical.

In order to pre-heat the carrier 1, the temperature T is increased from an initial temperature T0 to at least a first temperature threshold T1 (see also Figure 3). In the following, designating the carrier 1 as "pre-heated" means that the temperature T is at least T1. At a first point of time t1, the temperature T has reached T1.

Subsequent to reaching the first temperature T1, i.e. subsequent to the first point of time t1, the ceramic substrate 2 and the pre-heated carrier 1 with the powder-including layer 41" disposed in-between are pressed against one another with a pressure p of at least a first pressure threshold p1 (see also Figure 5). That is, in a state, in which the temperature T is permanently at least the first threshold temperature T1, the pressure p is increased from less than or equal to an initial pressure threshold p0 to at least the first pressure threshold p1. In Figure 6, a second point of time t2 designates the point of time at which the increasing pressure p reaches the first pressure threshold p1.

The initial pressure threshold p0 is sufficiently low to allow for a certain relative movement between the carrier 1 and the substrate 2 so that, when the temperature T is increased from T0 to at least the first threshold temperature T1, no substantial tensile load affects the ceramic layer 20. A suitable value for the initial pressure threshold p0 is, without being restricted to, 8.5E-04 MPa (megapascal). The low pressure threshold p0 may substantially be caused by the self-weight of the elements of the stack with the substrate 2, the powder-including layer 41" and the carrier 1, and, as far as provided, by the self-weights of the foil layer and the first pressing tool element 61.

The first pressure threshold p1 and the first temperature threshold T1 are sufficiently high to allow for fast and reliably producing the first joining layer 41 from the powder-including layer 41" by sintering. A suitable value for the first pressure threshold p1 is, without being restricted to, at least 20 MPa or even at least 30 MPa. A suitable value for the first temperature threshold T1 is, without being restricted to, a temperature which allows for sintering the powder-including layer when it is heated to that temperature. For instance, the first temperature threshold T1 may be at least 200°C or even at least 300°C.

After simultaneously keeping the pressure p at at least the first pressure threshold p1 and the temperature T at at least the first temperature threshold T1 for at least a minimum sintering time Δt, the powder-including layer 41" is sintered and thereby converted into the first joining layer 41 which forms a stable sintered joint between the carrier 1 and the substrate 2. In Figure 6, a third point of time t3 designates the point of time at which the minimum sintering time Δt lapses. That is, the minimum sintering time Δt is the time difference between the third point of time t3 and the second point of time t2.

Subsequent to the minimum sintering time Δt, the temperature T may be decreased to below the first temperature threshold T1 (e.g. to the initial temperature T0) and the pressure p may be decreased to below the first pressure threshold p1 (e.g. to below the initial pressure threshold p0). A suitable value for the minimum sintering time Δt is, without being restricted to, at least 30 s (seconds), or even at least 120 s.

In order to prevent damage to the ceramic layer 20 due to excessive pressure, the pressure p may be kept below 50 MPa during the whole process, in particular during the minimum sintering time Δt. Optionally, the initial pressure p0 may be zero which can be achieved by pre-heating the carrier 1 in a state in which the carrier 1 is not yet placed on the substrate 2 and by subsequently placing the pre-heated carrier 1 on the substrate 2 with the powder-including layer 41" disposed in-between so that the powder-including layer 41" adjoins both the pre-heated carrier 1 and the substrate 2. Also optionally, the whole sintering process (i.e. the sintering of the powder-including layer 41") may be a dry sintering process so that no liquid phases occur within the powder-including layer 41". During the sintering process, the carrier 1 and the substrate 2 are not melted.

For heating the carrier 1 to the mentioned temperatures T, any suitable heating may be used. In Figures 3 and 5, the heating 10 is shown only schematically. For instance, the heating 10 may be integrated in the second pressing tool element 62 (e.g. as an electrical heating resistor). The heating 10 may also be external to the second pressing tool element 62. For example, the heating 10 may be a hot plate that is brought into contact with and heats the second pressing tool element 62. It is also possible that the heating 10 is an inductive heating.

Irrespective of the type of heating 10, heating the carrier 1 may include indirectly heating the carrier 1 by heat that disperses from the second pressing tool element 62 via the first pressing tool element 61 (and, if provided, the foil layer 7, 8) and via the substrate 2 and the powder-including layer 41".

If the first pressing tool element 61 is a flexible pressure pillow, the grade of flexibility may be adjusted by its shore-A-hardness. The pressure caused by a first pressing tool element 61 formed as a flexible pressure pillow is as closer to a hydrostatic pressure the lower the shore-A-hardness of the pressure pillow is. For a first pressing tool element 61 formed as a flexible pressure pillow, a suitable shore-A-hardness may be less than or equal to 90, e.g. in a range from 10 to 90 (at a temperature of the pressure pillow of 20°C in every case). However, it is to be noted that instead of a flexible pressure pillow, a rigid first pressing tool element 61, for example made of metal (e.g. steel), may also be used.

When the sintering process is completed, i.e. subsequent to the minimum sintering time Δt, the composite which includes the carrier 1, the ceramic substrate 2 and the first joining layer 41 may be removed from the pressing tool 6 and, if provided, the spacer 9. In order to achieve an electronic assembly 100 described with reference to Figure 1, one or more electronic components 3, e.g. semiconductor chips, may be mounted on the ceramic substrate 2 using a second joining layer 42, and electrically interconnected using interconnects 5, e.g. one or more bonding wires.

Figure 7 shows an arrangement according to Figure 5. The only difference to the arrangement of Figure 5 is that the carrier 1 has a plurality of cooling fins 11. As illustrated, the cooling fins 11 may, at least during the minimum sintering time Δt, be disposed at that side of the carrier 1 facing away from the substrate 2.

Spatially relative terms such as "under", "below", "lower", "over", "upper" and the like, are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description.

## Claims

1. A method for producing a sintered joint between a ceramic substrate (2) and a carrier (1), the ceramic substrate (2) comprising a ceramic layer (20), a first substrate metallization layer (21) attached to the ceramic layer (20) and a second substrate metallization layer (22) attached to the ceramic layer (20), the ceramic layer (20) disposed between the first substrate metallization layer (21) and the second substrate metallization layer (22), the second substrate metallization layer (22) patterned to include at least two conductor tracks (221, 222) disposed distant from one another, the method comprising:
pre-heating the carrier (1) by increasing a temperature (T) of the carrier (1) from an initial temperature (T0) to at least a first threshold temperature (T1);
increasing a pressure (p), with which the pre-heated carrier (1), the ceramic substrate (2) and a powder-including layer (41") disposed between the pre-heated carrier (1) and the ceramic substrate (2) and adjoining both the carrier (1) and the first substrate metallization layer (21) are pressed against one another, from an initial pressure of less than or equal to an initial pressure threshold (p0) to at least a first pressure threshold (p1);
sintering the powder-including layer (41") by simultaneously keeping the pressure (p) for at least a minimum sintering time (Δt) at at least the first pressure threshold (p1) and the temperature (T) of the carrier (1) at at least the first temperature threshold (T1) so that the powder-including layer (41") is converted into a joining layer (41) joining the carrier (1) and the ceramic substrate (2); wherein
the first temperature threshold (T1) is a temperature which allows for sintering the powder-including layer (41") when it is heated to that temperature.

2. The method of claim 1, wherein pressing the pre-heated carrier (1) and the ceramic substrate (2) with the powder-including layer (41") disposed in-between against one another comprises
disposing a stack which comprises the carrier (1), the ceramic substrate (2) and the powder-including layer (41") disposed between the carrier (1) and the ceramic substrate (2) between a first pressure piece (61) formed as a flexible pressure pillow and a second pressure piece (62) so that the carrier (1) is disposed between the first pressure piece (61) and the ceramic substrate (2) and that, in an orthogonal projection of the carrier (1) and the substrate (2) of the stack onto a projection plane (E), an outline of the orthogonal projection of the substrate (2) is fully inside but distant from an outline of the projection of the carrier (1) into the projection plane (E); and
pressing the pre-heated carrier (1), the ceramic substrate (2) and the powder-including layer (41") disposed between the pre-heated carrier (1) and the ceramic substrate (2) against one another by pressing the first pressure piece (61) and the second pressure piece (62) towards one another.

3. The method of claim 2 or 3, wherein, adjacent to the substrate (2), a spacer (9) is disposed between the carrier (1) and the second pressure piece (62).

4. The method of any of the preceding claims, wherein the first pressure threshold (p1) is at least 20 MPa or at least 30 MPa.

5. The method of any of the preceding claims, wherein the pressure (p) is, at least for the minimum sintering time (ΔT), below 50 MPa.

6. The method of any of the preceding claims, wherein the minimum sintering time (ΔT) is at least 30 s or at least 120 s.

7. The method of any of the preceding claims, wherein the first temperature threshold (T1) is at least 200°C.

8. The method of any of the preceding claims, wherein the first temperature threshold (T1) is at least 300°C.

9. The method of any of the preceding claims, wherein, after the minimum sintering time (ΔT),
the temperature (T) is decreased to below the first temperature threshold (T1); and
the pressure (p) is decreased to below the first pressure threshold (p1).

10. The method of any of the preceding claims, wherein the carrier (1) consists of or comprises metal.

11. The method of any of the preceding claims, wherein the carrier (1) comprises a plurality of cooling fins (11) which are, at least during the minimum sintering time (ΔT), disposed at that side of the carrier (1) facing away from the ceramic substrate (2).

12. The method of any of the preceding claims, wherein the powder-including layer (41") consists of or comprises a metal powder.

13. The method of claim 12, wherein the metal powder is a silver powder.

## Patentansprüche

1. Verfahren zur Herstellung einer gesinterten Verbindung zwischen einem Keramiksubstrat (2) und einem Träger (1), wobei das Keramiksubstrat (2) eine Keramikschicht (20), eine erste Substratmetallisierungsschicht (21), die an der Keramikschicht (20) befestigt ist, und eine zweite Substratmetallisierungsschicht (22), die an der Keramikschicht (20) befestigt ist, umfasst, wobei die Keramikschicht (20) zwischen der ersten Substratmetallisierungsschicht (21) und der zweiten Substratmetallisierungsschicht (22) angeordnet ist, wobei die zweite Substratmetallisierungsschicht (22) so gemustert ist, dass sie mindestens zwei Leiterbahnen (221, 222) enthält, die voneinander beabstandet angeordnet sind, wobei das Verfahren umfasst:
Vorheizen des Trägers (1) durch Erhöhen einer Temperatur (T) des Trägers (1) von einer Anfangstemperatur (T0) bis zu mindestens einer Schwellentemperatur (T1);
Erhöhen eines Drucks (p), mit dem der vorgeheizte Träger (1), das Keramiksubstrat (2) und eine ein Pulver enthaltende Schicht (41"), die zwischen dem vorgeheizten Träger (1) und dem Keramiksubstrat (2) angeordnet ist und an den Träger (1) und die erste Substratmetallisierungsschicht (21) angrenzt, gegeneinander gedrückt werden, von einem Anfangsdruck von weniger als oder gleich einer Anfangsdruckschwelle (p0) bis zu mindestens einer ersten Druckschwelle (p1);
Sintern der ein Pulver enthaltenden Schicht (41") durch gleichzeitiges Halten des Drucks (p) für mindestens eine Mindestsinterzeit (Δt) bei mindestens der ersten Druckschwelle (p1) und der Temperatur (T) des Trägers (1) bei mindestens der ersten Temperaturschwelle (T1), sodass die ein Pulver enthaltende Schicht (41") in eine Verbindungsschicht (41) umgewandelt wird, welche den Träger (1) mit dem Keramiksubstrat (2) verbindet; wobei
die erste Temperaturschwelle (T1) eine Temperatur ist, welche ein Sintern der ein Pulver enthaltenden Schicht (41") ermöglicht, wenn sie auf diese Temperatur erhitzt wird.

2. Verfahren gemäß Anspruch 1, wobei das Drücken des vorgeheizten Trägers (1) und des Keramiksubstrats (2) mit der ein Pulver enthaltenden Schicht (41"), die dazwischen angeordnet ist, gegeneinander umfasst:
Anordnen eines Stapels, der den Träger (1), das Keramiksubstrat (2) und die ein Pulver enthaltende Schicht (41"), die zwischen dem Träger (1) und dem Keramiksubstrat (2) angeordnet ist, umfasst, zwischen einem ersten Druckstück (61), das als ein flexibler Druckkissen ausgebildet ist, und einem zweiten Druckstück (62), sodass der Träger (1) zwischen dem ersten Druckstück (61) und dem Keramiksubstrat (2) angeordnet ist und dass, in einer orthogonalen Projektion des Trägers (1) und des Substrats (2) des Stapels auf eine Projektionsebene (E), ein Umriss der orthogonalen Projektion des Substrats (2) vollständig innerhalb, aber beabstandet von einem Umriss der Projektion des Trägers (1) auf die Projektionsebene (E) ist; und
Drücken des vorgeheizten Trägers (1), des Keramiksubstrats (2) und der ein Pulver enthaltenden Schicht (41''), die zwischen dem vorgeheizten Träger (1) und dem Keramiksubstrat (2) angeordnet ist, gegeneinander durch Drücken des ersten Druckstücks (61) und des zweiten Druckstücks (62) zueinander hin.

3. Verfahren gemäß einem der Ansprüche 2 oder 3, wobei, neben dem Substrat (2), ein Abstandshalter (9) zwischen dem Träger (1) und dem zweiten Druckstück (62) angeordnet ist.

4. Verfahren gemäß einem der vorherigen Ansprüche, wobei die erste Druckschwelle (p1) mindestens 20 MPa oder mindestens 30 MPa ist.

5. Verfahren gemäß einem der vorherigen Ansprüche, wobei der Druck (p), mindestens für die Mindestsinterzeit (Δt), unter 50 MPa liegt.

6. Verfahren gemäß einem der vorherigen Ansprüche, wobei die Mindestsinterzeit (Δt) mindestens 30 s oder mindestens 120 s ist.

7. Verfahren gemäß einem der vorherigen Ansprüche, wobei die erste Temperaturschwelle (T1) mindestens 200°C ist.

8. Verfahren gemäß einem der vorherigen Ansprüche, wobei die erste Temperaturschwelle (T1) mindestens 300°C ist.

9. Verfahren gemäß einem der vorherigen Ansprüche, wobei, nach der Mindestsinterzeit (Δt), die Temperatur (T) unterhalb der ersten Temperaturschwelle (T1) reduziert wird; und der Druck (p) unterhalb der ersten Druckschwelle (p1) reduziert wird.

10. Verfahren gemäß einem der vorherigen Ansprüche, wobei der Träger (1) aus einem Metall besteht oder ein Metall umfasst.

11. Verfahren gemäß einem der vorherigen Ansprüche, wobei der Träger (1) eine Vielzahl Kühlrippen (11) umfasst, die, mindestens während der Mindestsinterzeit (Δt), an der Seite des Trägers (1) angeordnet sind, welche von dem Keramiksubstrat (2) abgewandt ist.

12. Verfahren gemäß einem der vorherigen Ansprüche, wobei die ein Pulver enthaltende Schicht (41") aus einem Metallpulver besteht oder ein Metallpulver umfasst.

13. Verfahren gemäß Anspruch 12, wobei das Metallpulver ein Silberpulver ist.

## Revendications

1. Procédé de production d'un joint fritté entre un substrat céramique (2) et un support (1), le substrat céramique (2) comprenant une couche céramique (20), une première couche de métallisation de substrat (21) fixée à la couche céramique (20) et une seconde couche de métallisation de substrat (22) fixée à la couche céramique (20), la couche céramique (20) étant disposée entre la première couche de métallisation de substrat (21) et la seconde couche de métallisation de substrat (22), la seconde couche de métallisation de substrat (22) étant structurée de manière à inclure au moins deux pistes conductrices (221, 222) éloignées l'une de l'autre, le procédé comprenant :
le préchauffage du support (1) par augmentation de la température (T) du support (1) depuis une température initiale (T0) jusqu'à au moins une première température-seuil (T1) ;
l'augmentation d'une pression (p), avec laquelle le support préchauffé (1), le substrat céramique (2) et une couche contenant de la poudre (41") disposée entre le support préchauffé (1) et le substrat céramique (2) et voisine à la fois du support (1) et de la première couche de métallisation de substrat (21) sont pressés les uns contre les autres, à partir d'une pression initiale inférieure ou égale à un seuil de pression initiale (p0) jusqu'à un premier seuil de pression (p1) ;
le frittage de la couche contenant de la poudre (41") en maintenant la pression (p) simultanément pendant un temps minimum de frittage (Δt) à le ou les premiers seuils de pression (p1) et la température (T) du support (1) à le ou les premiers seuils de température (T1) de manière à ce que la couche contenant de la poudre (41") soit convertie en une couche de jonction (41) joignant le support (1) et le substrat céramique (2) ; dans lequel
le premier seuil de température (T1) est une température qui permet de fritter la couche contenant de la poudre (41") quand elle est chauffée à cette température.

2. Procédé selon la revendication 1, dans lequel le pressage l'un contre l'autre du support préchauffé (1) et du substrat céramique (2) avec la couche contenant de la poudre (41") disposée entre eux comprend :
la disposition d'un empilement comprenant le support (1), le substrat céramique (2) et la couche contenant de la poudre (41") disposée entre le support (1) et le substrat céramique (2) entre un premier élément de pression (61) formé comme un oreiller de pression flexible et un second élément de pression (62) de manière à ce que le support (1) soit disposé entre le premier élément de pression (61) et le substrat céramique (2) et que, dans une projection orthogonale du support (1) et du substrat (2) de l'empilement sur un plan de projection (E), un contour de la projection orthogonale du substrat (2) soit complètement à l'intérieur mais distante d'un contour de la projection du support (1) dans le plan de projection (E) ; et
le pressage du support préchauffé (1), du substrat céramique (2) et de la couche contenant de la poudre (41") disposée entre le support préchauffé (1) et le substrat céramique (2) les uns contre les autres par pressage du premier élément de pression (61) et du second élément de pression (62) en direction l'un de l'autre.

3. Procédé selon l'une des revendications 2 ou 3, dans lequel, près du substrat (2), une entretoise (9) est disposée entre le support (1) et le second élément de pression (62).

4. Procédé selon l'une des revendications précédentes, dans lequel le premier seuil de pression (p1) est d'au moins 20 MPa ou d'au moins de 30 MPa.

5. Procédé selon l'une des revendications précédentes, dans lequel la pression (p) est, au moins pendant le temps minimum de frittage (ΔT), en-dessous de 50 MPa.

6. Procédé selon l'une des revendications précédentes, dans lequel le temps minimum de frittage (ΔT) est au moins de 30 s ou au moins de 120 s.

7. Procédé selon l'une des revendications précédentes, dans lequel le premier seuil de température (T1) est d'au moins 200°C.

8. Procédé selon l'une des revendications précédentes, dans lequel le premier seuil de température (T1) est d'au moins 300°C.

9. Procédé selon l'une des revendications précédentes, dans lequel, après le temps minimum de frittage (ΔT),
la température (T) est abaissée en-dessous du premier seuil de température (T1) ; et
la pression (p) est abaissée en-dessous du premier seuil de pression (p1).

10. Procédé selon l'une des revendications précédentes, dans lequel le support (1) se compose d'un métal ou comprend un métal.

11. Procédé selon l'une des revendications précédentes, dans lequel le support (1) comprend une pluralité d'ailettes de refroidissement (11) qui sont, au moins pendant le temps minimum de frittage (ΔT), disposées sur le côté du support (1) à l'opposé du substrat céramique (2).

12. Procédé selon l'une des revendications précédentes, dans lequel la couche contenant de la poudre (41") se compose d'une poudre métallique ou comprend une poudre métallique.

13. Procédé selon la revendication 12, dans lequel la poudre métallique est une poudre d'argent.
